# Europäisches Patentamt
# European Patent Office
# Office européen des brevets

(19)

(11) Publication number: **0 015 161**
**B1**

(12)

# EUROPEAN PATENT SPECIFICATION

(45) Date of publication of patent specification: **15.12.82**

(51) Int. Cl.³: **H 03 J 7/28, H 03 J 1/16**

(21) Application number: **80300566.9**

(22) Date of filing: **26.02.80**

(54) Electronically tunable receiver.

(30) Priority: **26.02.79 JP 22403/79**

(43) Date of publication of application:
**03.09.80 Bulletin 80/18**

(45) Publication of the grant of the patent:
**15.12.82 Bulletin 82/50**

(84) Designated Contracting States:
**DE FR GB**

(56) References cited:
**DE - A - 2 537 674**
**GB - A - 762 922**
**GB - A - 2 000 403**
**US - A - 3 665 319**

(73) Proprietor: **SHARP KABUSHIKI KAISHA**
**22-22 Nagaike-cho Abeno-ku**
**Osaka 545 (JP)**

(72) Inventor: **Konishi, Hideo 383-2 Tenbayashi**
**Oazaiida Hachihonmatsu-cho**
**Higashihiroshima-shi Hiroshima-ken (JP)**
Inventor: **Matsuoka, Kazunori**
**2226 Oazaiida Hachihonmatsu-cho**
**Higashihiroshima-shi Hiroshima-ken (JP)**
Inventor: **Gouya, Takao**
**332 Oazaiida Hachihonmatsu-cho**
**Higashihiroshima-shi Hiroshima-ken (JP)**

(74) Representative: **Wright, Peter David John et al,**
**R.G.C. Jenkins & Co. Chancery House 53-64**
**Chancery Lane**
**London WC2A 1QU (GB)**

Courier Press, Leamington Spa, England.

Electronically tunable receivers

Technical field

This invention relates to an electronically tunable receiver, and more particularly to a receiver in which the frequency of a local oscillator can be swept at a controllable rate, and a switch is provided for alternative selection of DX reception and LOCAL reception.

Background art

It is known to provide, in an electronically tunable receiver, a sweep rate control knob which can be used to adjust the rate at which the tuning frequency is swept during a tuning operation.

It is also known to provide a DX/LOCAL selector switch for selecting between a mode for reception of DX (weak intensity and long distance) broadcasting signals and LOCAL (strong signals and short distance) broadcasting signals.

During the operation of a receiver provided with both the above facilities, it may occur that the DX/LOCAL selector switch is turned to set the DX reception mode while the sweep rate control knob is set for a high sweep speed. The sweep speed would then have to be adjusted, or the operator would have to pay careful attention to listening to the relatively weak DX broadcasting signals during the tuning operation.

On the other hand, during the LOCAL reception mode, the broadcasting signals are relatively strong and the tuning operation is relatively easy even at a high sweep speed. If the DX/LOCAL selector switch is switched from the DX to the LOCAL mode, a slow sweep speed setting would prolong the period of time required for completion of the tuning operation.

It would be desirable to install a DX/LOCAL mode selector which is responsive to the set sweep speed. However, this would involve practical difficulties.

If the broadcasting signals listened to during the DX receiver mode and the LOCAL receiver mode were of equal level, then an optimum tuning operation could be achieved by actuating only the DX/LOCAL mode selector. However, for car radio receivers, in which the location of the radio continuously varies with respect to the broadcasting stations, it is technically difficult to provide equal-level broadcasting signals during both the DX mode and the LOCAL mode.

It is therefore desirable to have a different sweep rate during the DX mode from that used during the LOCAL mode, in order to achieve a prompt and accurate tuning operation.

Furthermore, there are various requirements for the design of car radio receivers mounted on an instrument panel in front of the driver. The radio receivers are limited in shape and size depending upon the different types and makes of vehicles. The sweep speed control knob and the DX/LOCAL mode selector should be mounted in an appropriate relationship with the other operating switches and knobs. A large number of switches and knobs on radio receivers mounted in vehicles is undesirable for safe operation while driving.

Disclosure of invention

In accordance with the invention there is provided an electronically tunable receiver having means for sweeping the frequency of a local oscillator, means for controlling the sweep speed, and a DX/LOCAL switch means for switching between a DX mode and a LOCAL mode by altering the sensitivity of the receiver, characterised by a manually operable member which can be used to operate both said sweep speed controlling means and said DX/LOCAL switch means.

The operation of the receiver is made much more simple by virtue of the fact that only a single member needs to be operated in order to control both sweep speed and selection of DX/LOCAL mode. A further significant advantage which can be achieved is an effective increase in the useful area of the front panel of a radio receiver (such as a car radio receiver) to allow the addition of other functional and attractive features.

Furthermore, it is possible using the present invention to arrange for the sweep speed to be different during the DX and LOCAL modes. In a preferred embodiment, the sweep speed is arranged to be relatively low during the DX mode, and relatively high during the LOCAL mode.

A further preferred feature of the present invention is the provision of means for altering the direction in which the frequency of the LOCAL oscillator is swept, which means is also operated using the same member as is used for controlling sweep speed and selection between DX and LOCAL receiver modes.

Brief description of the drawings

Fig. 1 is a cross-sectional view of a selector knob for a radio receiver constructed in accordance with the present invention; and

Fig. 2 is a circuit diagram of a radio receiver embodying the present invention.

Detailed description of preferred embodiment

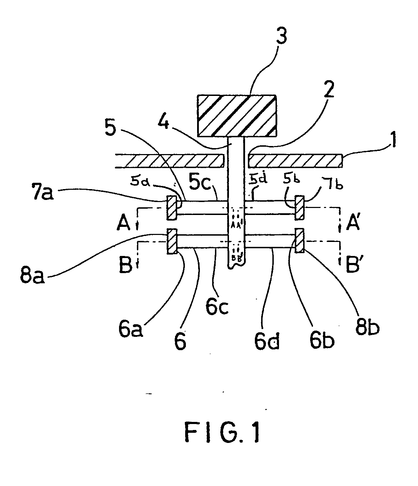

Referring now to Fig. 1, there is illustrated in a schematic cross-sectional side view a portion of a receiver constructed in accordance with the present invention, which includes a front panel 1. An upper surface of the front panel 1 is accessible to an operator and the inside assembly of the receiver is located below the front panel 1. The front panel 1 is provided with an insertion hole 2 in which a shaft 4 of an externally manually operable knob 3 can rotate for controlling the speed of sweeping the local oscillation frequency in association with selection between the DX and LOCAL modes. The lowest end of the shaft 4 is loosely supported in place in the interior of the radio receiver, although not shown. This knob has the functions of controlling the direction of the sweep operation and selecting between the DX and LOCAL modes in addition to the above mentioned control of sweep speed. Movable terminals 5 and 6 are disposed in parallel with each other on the shaft 4 and are spaced along the longitudinal direction of the shaft 4. One of the movable terminals 5 is used to control the speed and direction of the sweep operation of the local oscillation frequency, whereas the other movable terminal 6 is used to select between the DX and LOCAL receiver modes according to what AM or FM channel is to be received. Sweep direction and speed controlling elements 7a and 7b are installed along the rotation paths of both ends 5a and 5b of the movable terminal 5, whereas DX/LOCAL mode selecting elements 8a (8a$_1$ and 8a$_2$) and 8b (8b$_1$ and 8b$_2$) are installed along the rotation paths of both ends 6a and 6b of the remaining movable terminal 6. The rotation of the respective terminals describes a semicircular path. The controlling elements are held in place within the radio receiver.

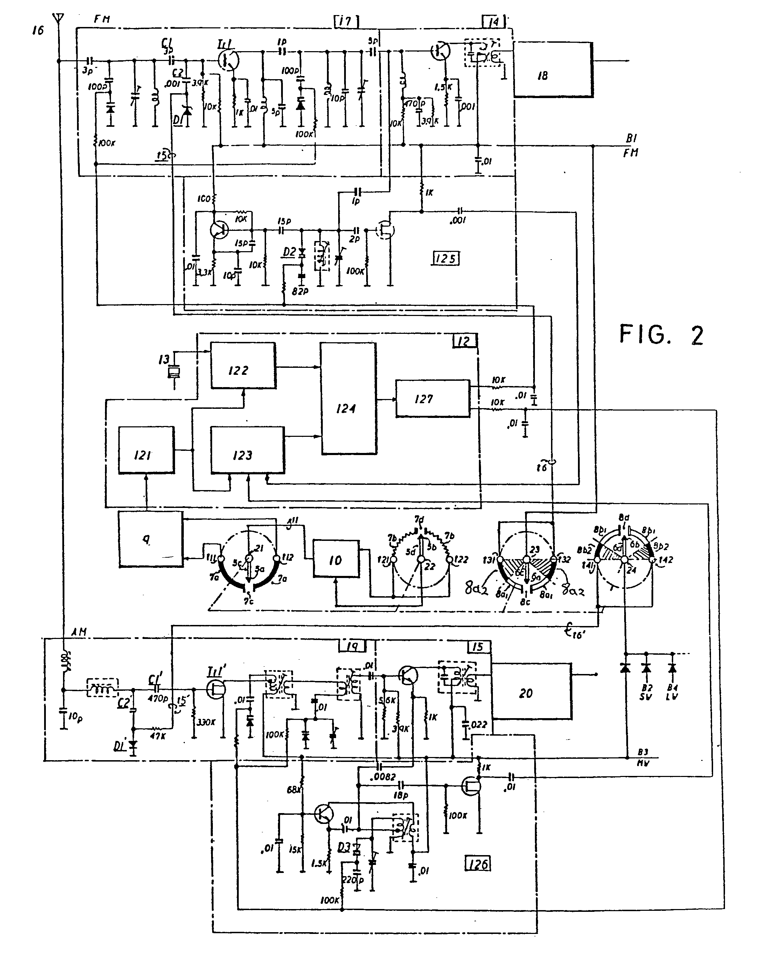

Fig. 2 is a schematic circuit representation of the radio receiver according to the present invention, wherein 21 through 24 show each quarter of the knob shaft in plan view taken along the lines A—A, A'—A', B—B and B'—B' of Fig. 1.

The one end 5a of a half segment 5c of the movable terminal 5 movable in union with the shaft part 21 rotates both clockwise and counterclockwise over an angular range of 90° from a neutral position 7c (at which there is a filler or a vacant cavity) between the sweep direction controlling elements 7a and 7a which may be made of an electrically good conductor such as silver or copper. Similarly, the one end 5b of the other segment 5d of the movable terminal 5 movable in union with the shaft part 22 can rotate clockwise and counterclockwise over an angular range of 90° from a neutral position 7d between sweep speed controlling elements 7b and 7b on which are disposed an electrically resistive coating such as carbon.

The end 6a of one arm 6c of the terminal 6 movable in union with the shaft part 23 rotates clockwise and counterclockwise over a range of 90° from a neutral position 8c between two pairs of DX/LOCAL mode selecting elements 8a$_1$ and 8a$_2$, the DX mode controlling elements 8a$_1$ being engaged by the end 6a during clockwise and counterclockwise rotation over a range of 60° and the LOCAL mode controlling elements 8a$_2$ occupying the remaining rotation range. The DX mode controlling element 8a$_1$ comprises electrically insulating material and the LOCAL mode controlling element 8a$_2$ comprises an

electrically good conductor such as silver or copper.

The movable terminal 6c operatively associated with the shaft part 23 becomes operative while in the FM receiver mode. The end 6b of the other arm 6d of the movable terminal 6 on the shaft part 24 is rotatable clockwise and counterclockwise over a range of 90° from a neutral position 8d which is sandwiched by the DX mode controlling elements 8b$_1$ of insulating material, each of which occupies a rotation range of 60°, and the LOCAL mode controlling elements 8b$_2$ of an electrically good conductor such as silver or copper, which occupy the remaining rotation angle.

The movable terminal 6d on the shaft part 24 is operative under the AM (LW, MW and SW) receiving condition. It will be appreciated that the rotation ranges and locations of the DX mode controlling elements 8a$_1$ and 8b$_1$ and the LOCAL mode controlling elements 8a$_2$ and 8b$_2$ are freely selectable in accordance with the desired relationship with the sweep direction and speed.

The terminals t$_{11}$ and t$_{12}$ of the sweep direction controlling elements 7a are connected to an UP data input terminal and a DOWN data input terminal of a microcomputer 9. Both terminals t$_{21}$ and t$_{22}$ of the sweep speed controlling elements 7b are commonly connected to one frequency control input of an oscillator 10, while the fixed end of the movable terminal 5d on the shaft part 22 is connected to another input of the oscillator 10. The output of the oscillator 10 is connected via a line 11 to the fixed end of the movable terminal 5c on the shaft part 21. As the shaft part 22 rotates the active length of the controlling element 7b (between the end 5b of the movable terminal 5d and the terminal t$_{21}$ or t$_{22}$ of the controlling element 7b) varies, thus varying the value of resistance between the inputs of the oscillator 10. In this manner the oscillation frequency output of the oscillator 10 is externally controlled by varying the active length of the controlling element 7b.

The oscillator 10 has a digital oscillation frequency output (variable from 1 Hz to 20 Hz), the interval between pulses in this output corresponding to the spacing between two adjacent allotted broadcasting frequencies. The higher the frequency of the oscillator 10 the higher the sweep speed.

The reason why the oscillator 10 is designed to oscillate within a range of 1 Hz to 20 Hz is to avoid the situation where the sweep speed becomes too high for the operator to recognise and tune into his desired broadcasting signal. When the shaft part 22 is rotated clockwise from the neutral position 7d, the end 5a of the movable terminal 5c on the shaft part 21 moves in contact with the controlling element 7a having the terminal portion t$_{11}$, indicating to the microcomputer 9 through data inputs applied thereto that the sweep operation is to start with the lowest frequency and end with the highest one. If the shaft part 22 is rotated in the opposite direction, then the microcomputer 9 operates in the opposite manner.

It will be understood that the microcomputer 9 responds to the oscillation frequency of the oscillator 10 and executes data processing on the sweep speed. The microcomputer 9 may be replaced by an UP/DOWN counter.

As stated above, the movable terminal 6c fixed with respect to the shaft part 23 is used while the receiver is receiving any FM broadcasting signals. The stationary end of the movable terminal 6c is coupled with a positive DC power supply voltage $+B_1$. The common junction $t_6$ of terminals $t_{31}$ and $t_{32}$ of the LOCAL mode controlling elements $8a_2$ leads to an input terminal $t_5$ of an RF amplifier 17 as discussed hereinafter. The base electrode of an amplifying transistor $Tr_1$ within the RF amplifier 17 is connected to a plate of each of capacitors $C_1$ and $C_2$, the other plate of the capacitor $C_2$ being connected to the cathode of a Zener diode $D_1$ of which the anode is grounded.

An input terminal $t_5$ at the junction of the diode $D_1$ and the capacitor $C_2$ is supplied with the DC power supply voltage$+B_1$ so that the diode $D_1$ becomes conductive to lower the base voltage of the amplifying transistor $Tr_1$ and thus reduce its gain by approximately 20 dB. Assume now that the movable terminal 6c is turned clockwise away from the neutral position 8c. While the end 6a moves in contact with the DX mode controlling element $8a_1$, the supply voltage$+B_1$ is not developed at the common junction $t_6$ due to the insulating characteristics of that element $8a_1$. The result is that no DC voltage is supplied to the cathode of the Zener diode $D_1$ via the input terminal $t_5$ and the amplifying transistor $Tr_1$ performs amplification with a maximum gain to enable the DX receiver mode.

If the movable terminal 6c moves clockwise away from the neutral position 8c and rotates beyond the range of 60°, its end 6a slides on the LOCAL mode controlling element $8a_2$ of electrically conductive material, permitting the DC supply voltage $+B_1$ to be applied to the cathode of the diode $D_1$ through the common junction $t_6$ and the input terminal $t_5$. As a result of this, the diode $D_1$ is conductive to lower the base bias voltage of the amplifying transistor $Tr_1$ and thus its gain, thus enabling the LOCAL receiver mode. The above operation also occurs when the movable terminal 6c is rotated counterclockwise from the neutral position.

The movable terminal 6d is of use when the receiver is in the AM (LW, MW and SW) reception mode. DC power supply voltages $+B_2$, $+B_3$ and $+B_4$ are selectively applied to the stationary end of the movable terminal 6d via check diodes. Terminals $t_{41}$ and $t_{42}$ of the LOCAL mode controlling elements $8b_2$ are commonly connected, the common junction $t_6'$ leading to an input terminal $t_5'$ of an AM receiving RF amplifier 19. Depending upon the angular position of the movable terminal 6d, an amplifying transistor $Tr_1'$ is controlled in gain by a combination of capacitors $C_1'$ and $C_2'$ and a Zener diode $D_1'$, thus enabling the DX and LOCAL receiver modes as in the FM reception mode.

When the end 5b of the movable terminal 5d faces against the neutral position 7d, the respective movable terminals 5c, 6c and 6d also face against their neutral positions 7c, 8c and 8d. Upon clockwise rotation of the movable terminal 5d the sweep speed increases with an increase in the angular displacement from the neutral position. While the angular displacement is within a range of 0° to 60° (and the oscillation frequency of the oscillator 10 is 1 HZ to 10 Hz), the ends of the movable terminals 6c and 6d are in contact with DX mode controlling elements, and the amplifying transistor $Tr_1$ or $Tr_1'$ performs amplification with a maximum gain. If the angular displacement goes beyond 60°, the sweep speed further increases (the oscillation frequency of the oscillator 10 is within 10 HZ to 20 HZ). Under these circumstances the ends of the movable terminals 6c and 6d are in contact with LOCAL mode controlling elements so that the amplifying transistor $Tr_1$ or $Tr_1'$ suffers from a gain drop of approximately 20 dB in its amplifying performance. The sweep operation is conducted from the lowest frequency to the highest one because the respective movable terminals are rotated clockwise. A mode selector switch (not shown) decides whether the FM receiver mode or the AM receiver mode is operative. Once either of the modes has been selected the functions of other circuit elements associated with the non-selected mode are disabled. It is also possible for the DX/LOCAL mode selector switch to serve as the AM/FM mode selector, in which case only one of the movable terminals 6c and 6d may be needed.

The output of the microcomputer 9 which receives the digital outputs from the oscillator 10 is introduced into a latch circuit 121 within a PLL (phase locked loop) circuit 12 as denoted by the broken line, the output of the latch circuit 121 being supplied to respective dividers 122 and 123. The divider 122 divides the frequency of a crystal standard oscillator 13 by the contents of the latch circuit 121 and the output of the divider 122 is supplied to one input of a phase comparator 124. The divider 123, on the other hand, divides selectively the output of one or other of voltage-controlled oscillators 125 and 126 by a factor determined by the output of the latch circuit 121. The output of the divider 123 is supplied to another input of the phase comparator 124. The phase comparator 124 compares in phase its two inputs and supplies its resulting output to a low pass filter 127 of which the output is supplied back to the voltage-controlled oscillators 125 and 126. These voltage-controlled oscillators 125 and 126 have each a voltage controlled variable capacitance element $D_2$ and $D_3$ whose

capacitance is variable according to an applied voltage to its cathode to control the oscillation outputs of the oscillators 125 and 126 which form local oscillators within the radio receiver. The outputs of the oscillators are supplied to an FM mixer 14 and an AM mixer 15, respectively. If it is desirable to receive FM broadcasting signals via an antenna 16, then the FM/AM mode selector is turned to the FM side such that the received FM frequency is applied to a high frequency amplifier 17. The intermediate frequency corresponding to the frequency output of the local oscillator 125 is available from the mixer 14. This intermediate frequency output is amplified by way of an intermediate frequency amplifier 18. In the drawings, an AM receiving high frequency amplifier is labelled 19 and an AM receiving intermediate frequency amplifier is labeled 20. FM broadcasting signals range from 76 MHz to 90 MHz with stations separated by 100 KHz and an intermediate frequency of 10.7 MHz in Japan. FM stations in Europe are separated by 50 KHz within a range of 87.50 to 108.10 MHz.

MW broadcasting stations are separated by 9 KHz within a frequency range of 531—1,602 KHz with the intermediate frequency being defined as 455 KHz in Japan. LW stations extend from 155 to 281 KHz in Europe.

In the receiver of the invention, the speed and direction of sweeping the local oscillation frequency are governed by the output of the microcomputer 9 responsive to the actuation of the knob 3 by way of the latch circuit 121, and selection of the DX and LOCAL modes is accomplished by the actuation of the knob 3 at the same time.

## Claims

1. An electronically tunable receiver having means (9, 10, 12) for sweeping the frequency of a local oscillator (125, 126), means (5b, 5d, 7b) for controlling the sweep speed, and a DX/LOCAL switch means (6, 8a, 8b) for switching between a DX mode and a LOCAL mode by altering the sensitivity of the receiver, characterised by a manually operable member (3) which can be used to operate both said sweep speed controlling means (5b, 5d, 7b) and said DX/LOCAL switch means (6, 8a, 8b).

2. A receiver as claimed in claim 1, wherein said sweep speed controlling means (5b, 5d, 7b) is so arranged that the sweep speed is relatively low when the switch means (6, 8a, 8b) is switched to the DX mode, and relatively high when the switch means (6, 8a, 8b) is switched to the LOCAL mode.

3. A receiver as claimed in claim 1 or claim 2, wherein the manually operable manner (3) can also be operated to alter the direction of sweep.

4. An electronically tunable receiver as claimed in any preceding claim, wherein said local oscillator comprises a voltage-controlled oscillator (125, 126) controlled by a PLL (phase locked loop) circuit (12).

5. An electronically tunable receiver as claimed in any preceding claim, wherein said manually operable member (3) is operable to move a first member (5) for controlling the sweep speed and a second member (6) for selecting between DX and LOCAL receiver modes, said movable members (5, 6) being located on a common shaft (4).

6. An electronically tunable receiver as claimed in any preceding claim, wherein said manually operable member (3) can be rotated to operate the sweep speed controlling means (5b, 5d, 7b) and said DX/LOCAL switch means (6, 8a, 8b).

## Patentansprüche

1. Elektronisch abstimmbarer Empfänger mit einer Einrichtung (9, 10, 12) zur Durchstimmung der Frequenz eines lokalen Oszillators (125, 126), einer Einrichtung (5b, 5d, 7b) zur Einstellung der Durchstimmgeschwindigkeit, und mit einer DX/LOCAL-Umschaltvorrichtung (6, 8a, 8b) zur umschaltbaren Veränderung der Empfängerempfindlichkeit zwischen DX-Empfang (schwaches Signal, große Senderentfernung) und LOCAL-Empfang (starkes Signal, geringe Senderentfernung) gekennzeichnet durch ein manuell betätigbares Glied (3) in Doppelfunktion zur Betätigung sowohl der Einstelleinrichtung (5b, 5d, 7b) für die Durchstimmgeschwindigkeit als auch der DX/LOCAL-Umschaltvorrichtung (6, 8a, 8b).

2. Empfänger nach Anspruch 1, dadurch gekennzeichnet, daß über die Einstelleinrichtung (5b, 5d, 7b) für die Durchstimmgeschwindigkeit eine relativ niedrige Durchstimmgeschwindigkeit einstellbar ist, wen die DX/LOCAL-Umschaltvorrichtung (6, 8a, 8b) auf DX-Empfang eingestellt ist und sich eine relativ hohe Durchstimmgeschwindigkeit ergibt, wenn die DX/LOCAL-Umschaltvorrichtung (6, 8a, 8b) auf LOCAL-Empfang umgeschaltet wird.

3. Empfänger nach Anspruch 1 oder 2, dadurch gekennzeichnet, daß das manuell betätigbare Glied (3) auch zur Änderung der Durchstimmrichtung betätigbar ist.

4. Empfänger nach einem der vorstehenden Ansprüche, dadurch gekennzeichnet, daß der lokale Oszillator eine über eine PLL-Schaltung (12) (PLL=Phase Locked Loop) überwachten spannungssteuerbaren Oszillator (125, 126) enthält.

5. Empfänger nach einem der vorstehenden Ansprüche, dadurch gekennzeichnet, daß über das manuell betätigbare Glied (3) ein erstes Teil (5) zur Einstellung der Durchstimmgeschwindigkeit und ein zweites Teil (6) zur Auswahl zwischen DX- und LOCAL-Empfang verscheibbar sind und daß die beiden beweglichen Teile (5, 6) auf einer gemeinsamen Achse (4) angeordnet sind.

6. Emfänger nach einem der vorstehenden Ansprüche, dadurch gekennzeichnet, daß das manuelle betätigbare Glied (3) zur Betätigung der Einstelleinrichtung (5b, 5d, 7b) für die Durchstimmgeschwindigkeit und der DX/LOCAL-Umschaltvorrichtung (6, 8a, 8b) drehbar ist.

## Revendications

1. Récepteur à accord électronique, comportant des moyens (9, 10, 12) pour faire varier par balayage la fréquence d'un oscillateur local (125, 126), des moyens (5b, 5d, 7b) pour régler la vitesse de ce balayage, et des moyens de commutation proche-lointain (6, 8a, 8b) permettant de sélectionner un mode de fonctionnement poure émetteurs proches ou un mode de fonctionnement pour émetteurs lointains en modifiant la sensibilité du récepteur, caractérisé par un organe de commande manuelle (3), qui peut être utilisé pour faire fonctionner à la fois lesdits moyens poure régler la vitesse de balayage (5b, 5d, 7b) et lesdits moyens de commutation proche-lointain (6, 8a, 8b).

2. Récepteur selon la revendication 1, dans lequel lesdits moyens de réglage de la vitesse de balayage (5b, 5d, 7b) sont réalisés de telle manière que la vitesse de balayage soit relativement faible quand les moyens de commutation (6, 8a, 8b) sont mis sur "lointain", et relativement élevée quand les moyens de commutation (6, 8a, 8b) sont sur "proche".

3. Récepteur selon la revendication 1 ou 2, dans lequel l'organe de commande manuelle (3) peut aussi être utilisé pour changer le sens du balayage.

4. Récepteur à accord électronique selon l'une quelconque des revendications précédentes, dans lequel ledit oscillateur local comprend un oscillateur à commande par tension (125, 126), commandé par un circuit PLL (12) (boucle bloquée en phase).

5. Récepteur à accord électronique selon l'une quelconque des revendications précédentes, dans lequel ledit organe de commande manuelle (3) peut être employé pour mouvoir un premier organe (5) qui règle la vitesse de balayage et un second organe (6) qui sélectionne le mode de fonctionnement "proche" ou "lointain" du récepteur, lesdits organes mobiles (5 et 6) étant montés sur un axe commun (4).

6. Récepteur à accord électronique selon l'une quelconque des revendications précédentes, dans lequel l'on peut faire tourner ledit organe de commande manuelle (3) pour faire fonctionner les moyens de réglage de la vitesse de balayage (5b, 5d, 7b) et les moyens de commutation proche-lointain (6, 8a, 8b).

FIG. 1

FIG. 2